# EUROPEAN PATENT APPLICATION

(11) **EP 4 838 269 A1**
(43) Date of publication of application: **11.11.2026**
(21) Application number: 25174538.6
(22) Date of filing: 06.05.2025
(51) Int. Cl.: G02B 5/08, G03F 7/00

(54) **EUV REFLECTOR**

(71) Applicant: ASML Netherlands B.V., 5500 AH Veldhoven (NL); Carl Zeiss SMT GmbH, 73447 Oberkochen (DE)
(72) Inventor: BLAUW, Michiel, Alexander, 5500 AH Veldhoven (NL); VAN DE KERKHOF, Marcus, Adrianus, 5500 AH Veldhoven (NL)
(74) Representative: ASML Netherlands B.V.

(57) **Abstract**

An EUV reflector comprising a ruthenium capping layer, a molybdenum silicon multilayer and a bilayer comprising an upper layer and a lower layer. The bilayer is positioned between the capping layer and the multilayer. The upper layer comprises carbon, boron, boron carbide, silicon, molybdenum and/or mixtures thereof. The lower layer comprises silicon nitride, amorphous carbon, diamond-like carbon, silicon carbide, boron nitride and/or mixtures thereof.

## Description

### FIELD

The present invention relates to an EUV reflector. The EUV reflector may form part of a lithographic apparatus, inspection apparatus or metrology apparatus.

### BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask or a reticle) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 2-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses reflective mirrors instead of lenses as optics. Mask blanks used in EUV lithography generally have a multilayer structure which functions as a Bragg reflector. The multilayers may be alternatingly molybdenum and silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Fourthly, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

An inspection apparatus may use EUV to inspect a substrate which has been patterned using lithography. A metrology apparatus may use EUV to measure properties of a substrate which has been patterned using lithography

EUV radiation may be produced by a laser produced plasma (LPP) radiation source. Within an LPP radiation source, a laser beam may be used to irradiate a target material in the form of fuel droplets (e.g. tin) so as to produce a plasma which will emit EUV radiation. An alternative radiation source may be used to generate EUV radiation. In the alternative radiation source, a laser beam may be used to irradiate a target material (e.g. tin) provided on a rotating element (e.g. a wheel, cylinder or drum) to produce a plasma which will emit EUV radiation. In both forms of radiation source, the laser beam may be an infrared radiation beam. A collector may be used to collect EUV radiation emitted from the plasma and direct the EUV radiation out of the radiation source.

Some DUV radiation (e.g. around 190 nm) may be emitted from the plasma in addition to EUV radiation. This DUV radiation may cause undesirable exposure of a lithographic substrate.

It may be desirable to provide an EUV reflector which is not disclosed or suggested by the prior art.

### SUMMARY

According to a first aspect of the invention there is provided an EUV reflector comprising a ruthenium capping layer, a bilayer comprising an upper layer and a lower layer, and a molybdenum silicon multilayer, wherein the bilayer is positioned between the capping layer and the multilayer, and wherein the upper layer comprises carbon, boron, boron carbide, silicon, molybdenum and/or mixtures thereof, and wherein the lower layer comprises silicon nitride, amorphous carbon, diamond-like carbon, silicon carbide, boron nitride and/or mixtures thereof.

Advantageously, the EUV reflector is reflective for EUV radiation and suppresses DUV radiation, and in addition the upper layer may provide robustness to the EUV reflector. The suppression of DUV radiation may be referred to as absorbing of DUV radiation.

The ruthenium capping layer and the bilayer may have a combined thickness of around 14 nm.

The lower layer of the bilayer may have a thickness of at least 8 nm.

The lower layer of the bilayer may have a thickness of around 10 nm.

The ruthenium capping layer and the bilayer may have a combined thickness of around 7 nm.

The lower layer of the bilayer may have a thickness of at least Snm.

The upper layer may be a monolayer.

The ruthenium capping layer may have a thickness between 1 and 2 nm.

A silicon layer may be provided between the upper layer and the lower layer of the bilayer.

An optical path length from an upper surface of the ruthenium capping layer to a bottom surface of the bilayer may be an integer multiple of 6.75 nm

According to a second aspect of the invention there is provided an illumination system comprising a plurality of EUV reflectors, wherein at least one of the EUV reflectors is according to the first aspect.

According to a third aspect of the invention there is provided a lithographic apparatus, inspection apparatus or metrology apparatus comprising an illumination system which includes at least one EUV reflector according to the second aspect of the invention.

According to a fourth aspect of the invention there is provided a lithographic apparatus, inspection apparatus or metrology apparatus comprising an illumination system which includes only one EUV reflector according to the first aspect of the invention.

Advantageously, using only one EUV reflector according to the first aspect may be sufficient to provide a desired suppression of DUV radiation.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus which includes an EUV reflector according to an embodiment of the invention;
- Figure 2 schematically depicts a system for (actinic) mask inspection which includes an EUV reflector according to an embodiment of the invention;
- Figure 3 schematically depicts an EUV reflector according to an embodiment of the invention; and
- Figure 4 schematically depicts an EUV reflector according to another embodiment of the invention.

### DETAILED DESCRIPTION

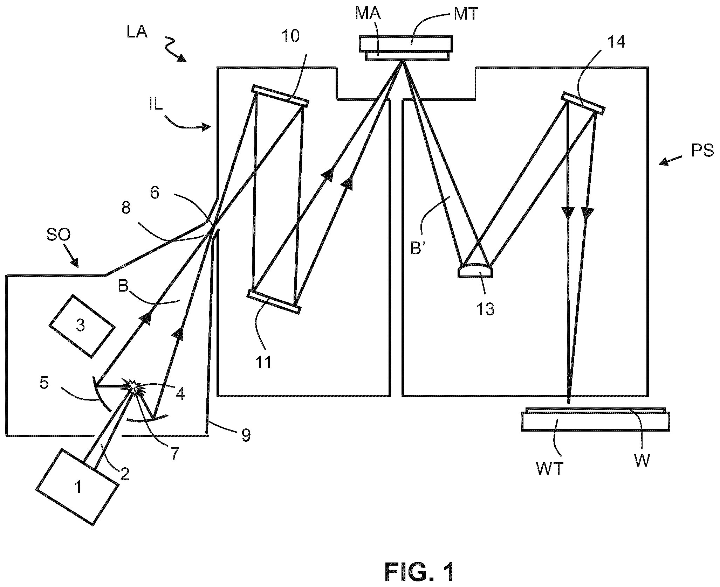

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. The illumination system IL is schematically depicted as consisting of two EUV reflectors 10, 11. However, the illumination system IL may comprise more than two EUV reflectors. For example, the illumination system IL may comprise four EUV reflectors. One or more of the EUV reflectors 10, 11 may be an EUV reflector according to an embodiment of the invention.

The illumination system IL may include a faceted field mirror device and a faceted pupil mirror device. The faceted field mirror device and faceted pupil mirror device together provide the EUV radiation beam B with a desired cross-sectional shape and a desired intensity distribution. The faceted field mirror device and faceted pupil mirror device are examples of EUV reflectors. The illumination system IL may include other EUV reflectors, e.g. mirrors or devices, in addition to, or instead of, the faceted field mirror device and faceted pupil mirror device.

Any EUV reflector of the illumination system IL may be according to an embodiment of the invention.

After being conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors). The mirrors are examples of EUV reflectors. The patterning device MA, which may be referred to as a reticle, is an example of an EUV reflector and may be according to an embodiment of the invention.

Any EUV reflector of the projection system PS may be according to an embodiment of the invention.

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

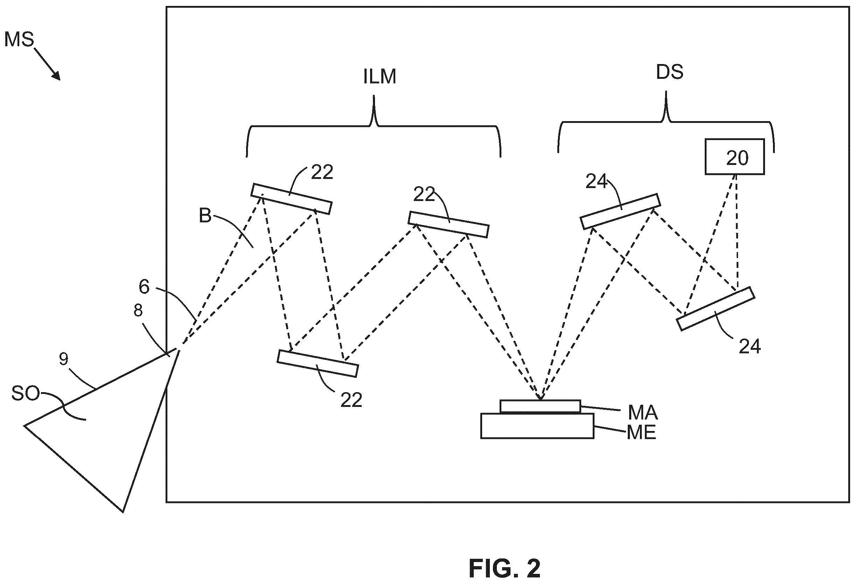

Figure 2 schematically depicts a system MS for (actinic) mask inspection. The mask inspection system MS can be used to identify or inspect defects in a mask to be used in a lithographic process by means of the lithographic apparatus described in figure 1. The mask inspection system MS comprises a radiation source SO, an illumination system ILM, a detection system DS and a mask stage ME.

The illumination system ILM is configured to condition an EUV radiation beam B before the EUV radiation beam B is incident upon the mask MA. The illumination system ILM may provide the EUV radiation beam B with a desired cross-sectional shape and a desired intensity distribution. The illumination system ILM may comprise a plurality of mirrors 22. The illumination system ILM may comprise one or more faceted mirror devices. Mirrors of the illumination system ILM are examples of EUV reflectors. Any EUV reflector of the illumination system ILM may be according to an embodiment of the invention.

The mask stage ME may be configured to move the mask MA relative to the EUV radiation beam B, so that the EUV radiation beam is incident upon different areas of the mask.

The detection system DS comprises a detector 20, and may in addition comprise a plurality of mirrors 24. The plurality of mirrors 24 may be configured to collect EUV radiation BR that has been reflected from the mask MA, and form an image of the mask MA on the detector 20 (which may be an imaging array). Mirrors of the detection system DS are examples of EUV reflectors. Any EUV reflector of the detection system DS may be according to an embodiment of the invention.

A processor (not depicted) may receive signals output from the detector 20 and use those signals to look for defects in the mask MA.

A metrology apparatus (not depicted) may also comprise an EUV radiation source, illumination system and EUV reflectors, along with one or more detectors. One or more EUV reflectors of a metrology apparatus and/or the illumination system comprised therein may be according to an embodiment of the invention.

The radiation source SO shown in Figures 1 and 2 is, for example, of a type which may be referred to as a laser produced plasma (LPP) source. A laser system 1 is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system (if present) may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO. The enclosing structure may be referred to as a housing 9.

The radiation source SO of the mask inspection system MS may correspond with the radiation source SO depicted in Figure 1. In the same way as depicted in Figure 1, the radiation source SO of the mask inspection system MS may focus the EUV radiation beam B to form an intermediate focus 6.

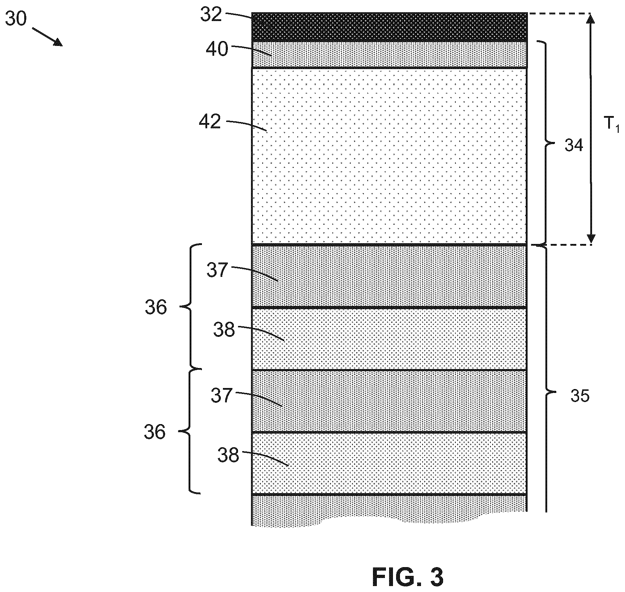

Figure 3 schematically depicts an EUV reflector 30 according to an embodiment of the invention. The EUV reflector comprises a ruthenium capping layer 32, a bilayer 34, and a multilayer 35 formed from molybdenum and silicon (MoSi). The EUV reflector 30 is configured to receive EUV radiation which is incident upon the capping layer 32.

The ruthenium capping layer 32 may for example have a thickness between 1 and 2 nm. A thickness of between 1 and 2 nm of ruthenium may be provided because this provides sufficient thickness of ruthenium to provide some protection to the bilayer 34 and other layers of the EUV reflector 30. In general, a thickness of at least 1 nm of ruthenium may be used as a capping layer.

The molybdenum silicon multilayer 35 comprises pairs of layers 36 which are configured to reflect EUV radiation at a desired wavelength. Each pair of layers 36 comprises an upper layer of molybdenum (Mo) 37 and a lower layer 38 of silicon (Si). In an embodiment, each pair of molybdenum silicon layers 36 may have a combined thickness of 6.75 nm. This thickness is such that the optical path length traveled by radiation starting from the top of a molybdenum layer 37 of a pair 36 to the bottom of a silicon layer 38 of that pair and then back to the top of the molybdenum layer of the pair is 13.5 nm. Because the path length is 13.5 nm, constructive interference occurs between radiation reflected from the top of the molybdenum layer 37 and radiation reflected from the top of the next molybdenum layer. A plurality of pairs of molybdenum silicon layers 36 may be provided, giving rise to strong reflection of radiation at a wavelength of 13.5 nm. Figure 3 schematically depicts that the molybdenum silicon multilayer 35 may include more than two pairs of molybdenum silicon layers 36. For example, the molybdenum silicon multilayer 35 may comprise tens of layers, e.g. around 50 layers.

The bilayer 34 comprises an upper layer 40 and a lower layer 42. The upper layer 40 comprises carbon, boron, boron carbide, silicon, molybdenum and/or mixtures thereof. The lower layer 42 comprises silicon nitride, amorphous carbon, diamond-like carbon, silicon carbide, boron nitride and/or mixtures thereof. The upper layer 40 may have a thickness of around 2 nm. A thickness of around 2 nm for the upper layer may be provided because this provides protection to other layers of the EUV reflector 30. In general, a thickness of at least 1 nm may be used.

The lower layer 42 may have a thickness of around 10 nm. The optical path length from the top of the ruthenium capping layer 32 to the bottom of the bilayer 34 may be 13.5 nm (the optical path length may be around 14 nm). The optical path length is labelled as T₁. Radiation travelling from the top of the ruthenium capping layer 32 to the bottom of the bilayer 34 and then back again will experience an optical path length of 27 nm. This is two times the EUV wavelength of 13.5 nm, and so will provide constructive interference of EUV radiation with a wavelength at 13.5 nm. In other words, the thickness of the combination of the ruthenium capping layer 32 and the bilayer 34 is selected to provide reflection of EUV radiation. The thickness of the combination of the ruthenium capping layer 32 and the bilayer 34 is selected to provide reflection of a desired wavelength of EUV radiation, e.g. 13.5 nm. The optical path length of a round trip through the ruthenium capping layer 32 and the bilayer 34 is an integer multiple of a desired EUV wavelength, e.g. 13.5 nm (in this embodiment the integer is 2).

Referring again to Figure 1, the radiation source SO may be configured to emit EUV radiation, for example having a wavelength of 13.5 nm. However, in practice the radiation source SO will also emit other wavelengths. For example, the radiation source will emit DUV radiation, e.g. having a wavelength around 190 nm (e.g. +/= 10 nm or more). This DUV radiation is undesirable because it will cause exposure of resist provided on a substrate W. Many resists used in lithography are configured to be particularly sensitive to radiation at a wavelength of around 190 nm because many lithographic apparatus use a DUV radiation source which emits radiation at 193 nm (e.g. an excimer laser). These resists may also be used in an EUV lithographic apparatus. However, if an EUV radiation source SO emits some DUV radiation, which is then incident upon a substrate W, this will cause unwanted exposure of the resist. This may for example have a negative effect upon the critical dimension of patterns exposed in the resist by the lithographic apparatus.

The EUV reflector depicted in Figure 3 advantageously suppresses DUV radiation, (as explained further below). When the EUV reflector 30 is included in the path being followed by the radiation beam B from the radiation source SO to the substrate W (see Figure 1), then the amount of DUV radiation incident upon the substrate is reduced significantly. Advantageously, this reduces resist exposure due to DUV radiation.

The reflected DUV radiation is suppressed due to the thickness of the lower layer 42 of the EUV reflector 30. The interface between the lower layer 42 and the first molybdenum layer 37 of the molybdenum silicon multilayer 35 applies a significant phase difference to the reflected DUV radiation. This phase difference in combination with the thickness of 10 nm of the lower layer 42, together with the upper layer 40 and the ruthenium layer 32, provides destructive interference of DUV radiation. The material(s) used in the lower layer is/are relatively transparent for DUV radiation (and not absorbing). It is the destructive interference that suppresses DUV radiation.

The thickness of the lower layer determines the degree to which suppression of DUV is provided, and in addition determines the wavelength of DUV at which the suppression is at a maximum. For example, a 10 nm thickness of silicon nitride will provide a suppression of around 100% (i.e. a reflectivity of around 0) at a wavelength of around 195 nm.

Reducing the thickness of the lower layer will move the wavelength of maximum DUV suppression to a shorter wavelength, and in addition will reduce the DUV suppression (i.e. increase the reflectivity) of the EUV reflector 30.

Referring again to Figure 3, the 10 nm thickness of the lower layer 42, together with the upper layer 40 and the ruthenium layer 32, provides strong suppression, via destructive interference, of radiation at a wavelength of around 195 nm. In addition, the 13.5 nm combined thickness of the ruthenium layer 32 and the bilayer 34 provides strong reflectance of radiation at a wavelength of 13.5 nm. Thus, the EUV reflector 30 reflects EUV radiation and in addition suppresses DUV radiation. In general, suppression of DUV in a wavelength range between 130 nm and 300 nm may be provided.

The 10 nm thickness of the silicon nitride layer 42 will absorb some EUV radiation. However, the amount of EUV radiation that is absorbed may be relatively small (e.g. less than 10%). A conventional filter membrane arrangement configured to suppress DUV radiation may absorb more than 10% of EUV, and thus the EUV reflector 30 may provide improved performance compared with a conventional filter membrane arrangement. DUV suppression provided by the EUV reflector 30 may be sufficiently strong that only one EUV reflector 30 is needed in a lithographic apparatus (or in an inspection apparatus or metrology apparatus). The EUV reflector 30 may be significantly more robust than a filter membrane.

Amorphous carbon, diamond-like carbon, silicon carbide, boron nitride or mixtures thereof may be used instead of silicon nitride. A mixture of silicon nitride with one or more of amorphous carbon, diamond-like carbon, silicon carbide or boron nitride may be used. The phase shift that is applied to the DUV radiation by the layer 42 may be different for different materials. A ratio of silicon nitride versus other materials may be adjusted in order to obtain a phase shift which provides the strongest destructive interference. The same may apply for other materials or combinations of materials of the layer 42. Similarly, the material or materials may be adjusted to provide a desired amplitude of DUV to contribute to destructive DUV interference.

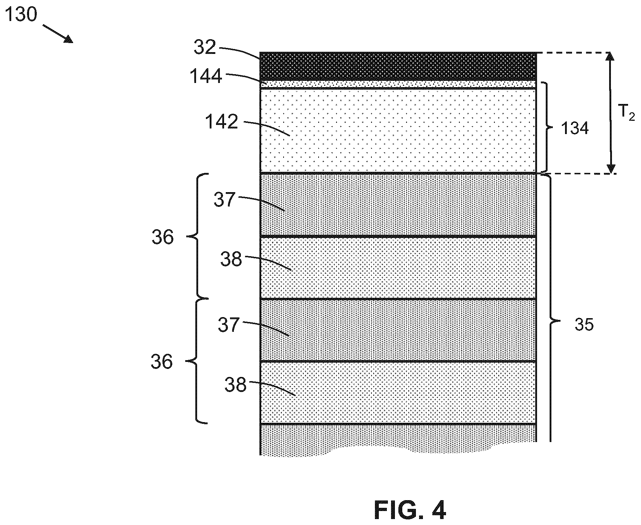

Figure 4 schematically depicts an EUV reflector 130 according to another embodiment of the invention. Some parts of the EUV reflector 130 correspond with the embodiment of Figure 3 and are not described again in connection with Figure 4. Other parts have a corresponding function but are different. Reference numerals for these parts have been incremented by 100.

The EUV reflector 130 comprises a ruthenium capping layer 32, a bilayer 134, and a multilayer 35 formed from molybdenum and silicon (MoSi) pairs 36. The EUV reflector 130 is configured to receive EUV radiation which is incident upon the capping layer 32.

The ruthenium capping layer 32 may for example have a thickness of between 1 and 2 nm. This may provide sufficient thickness of ruthenium to provide some protection to the bilayer 34 and other layers of the EUV reflector 30. In general, a thickness of at least 1 nm of ruthenium may be used as a capping layer.

The bilayer 134 comprises an upper layer 144 and a lower layer 142. The upper layer 144 comprises carbon, boron, boron carbide, silicon, molybdenum and/or mixtures thereof. The lower layer 142 comprises silicon nitride, amorphous carbon, diamond-like carbon, silicon carbide, boron nitride and/or mixtures thereof. The upper layer 144 may have a thickness of around 0.5 nm. The bilayer 134 may protect the multilayer 35.

Each pair of layers 36 of the multilayer comprises an upper layer of molybdenum (Mo) 37 and a lower layer 38 of silicon (Si). In an embodiment, each pair of molybdenum silicon layers 36 may have a combined thickness of 6.75 nm. Figure 4 schematically depicts that the molybdenum silicon multilayer 35 may include more than two pairs of molybdenum silicon layers 36. For example, the molybdenum silicon multilayer 35 may comprise tens of layers, e.g. around 50 layers.

The lower layer 142 may have a thickness of around 5 nm. The optical path length from the top of the ruthenium capping layer 32 to the bottom of the bilayer 134 may be around 7 nm (e.g. 6.75 nm). This optical path length is labelled as T₂. Radiation travelling from the top of the ruthenium capping layer 32 to the bottom of the bilayer 134 and then back again will experience an optical path length of around 14 nm (e.g. 13.5 nm). This is the EUV wavelength of 13.5 nm, and so will provide constructive interference of EUV radiation with a wavelength at 13.5 nm. In other words, the thickness of the combination of the ruthenium capping layer 32 and the bilayer 134 is selected to provide reflection of EUV radiation. The thickness of the combination of the ruthenium capping layer 32 and the bilayer 134 is selected to provide reflection of a desired wavelength of EUV radiation, e.g. 13.5 nm. The optical path length of a round trip through the ruthenium capping layer 32 and the bilayer 134 is an integer multiple of a desired EUV wavelength, e.g. 13.5 nm (in this embodiment the integer is 1).

The EUV reflector 130 depicted in Figure 4 advantageously suppresses DUV radiation. The DUV radiation is suppressed by the lower layer 142 of the EUV reflector 130. The thickness of the lower layer determines the suppression of the lower layer and in addition determines the wavelength at which the suppression is at a maximum. For example, a 5 nm thickness of silicon nitride may provide a suppression of around 90% (i.e. a reflectivity of around 0.1) at a wavelength of around 165 nm.

The around 5 nm thickness of the silicon nitride layer 142 provides strong suppression of radiation at a wavelength of around 165 nm. In addition, the around 7 nm combined thickness of the ruthenium layer 32 and the bilayer 134 provides strong reflectance of radiation at a wavelength of 13.5 nm. Thus, the EUV reflector 30 reflects EUV radiation and in addition suppresses DUV radiation. In general, suppression of DUV in the wavelength range from 100 nm to 200 nm may be provided.

Amorphous carbon, diamond-like carbon, silicon carbide, boron nitride or mixtures thereof may be used instead of silicon nitride. A mixture of silicon nitride with one or more of amorphous carbon, diamond-like carbon, silicon carbide or boron nitride may be used.

In an embodiment of the type depicted in Figure 3, the lower layer 42 may have a thickness between 9 and 10 nm, the upper layer may have a thickness of around 2 nm, and the ruthenium layer may have a thickness between 1 and 2 nm. This provides a combined thickness of around 13.5 nm. This provides constructive interference, and hence reflection, of EUV radiation with a wavelength of 13.5 nm. In an embodiment of the type depicted in Figure 4, the lower layer 42 may have a thickness of around 5 nm, the upper layer may have a thickness of around 0.75 nm, and the ruthenium layer may have a thickness of around 1 nm. This provides a combined thickness of around 6.75 nm. This also provides constructive interference, and hence reflection, of EUV radiation with a wavelength of 13.5 nm. In general, the optical path length from the top of the reflector to the bottom of the bilayer may be an integer multiple of 6.75 nm. In a further embodiment (not depicted) the upper layer, lower layer and ruthenium layer may have a combined thickness of 20.25 nm.

Embodiments in which the ruthenium capping layer and the bilayer have a combined thickness of around 14 nm (e.g. embodiments of the general type depicted in Figure 3) may be preferred over embodiments in which the ruthenium capping layer and the bilayer have a combined thickness of around 7 nm (e.g. embodiments of the general type depicted in Figure 4). This is because the thicker DUV suppressing layer will may provide stronger suppression of DUV. In general, it may be desirable for the DUV suppressing layer to have a thickness of at least 8 nm. It may be desirable for the DUV suppressing layer to have a thickness of around 10 nm.

In addition, embodiments in which the ruthenium capping layer and the bilayer have a combined thickness of around 14 nm (e.g. embodiments of the general type depicted in Figure 3) may be preferred over embodiments in which the ruthenium capping layer and the bilayer have a combined thickness of around 7, because they include sufficient depth to accommodate a combination of the ruthenium capping layer and the upper layer. The ruthenium capping layer and the upper layer may have a combined thickness of 3 nm or more. The ruthenium capping layer and the upper layer may have a combined thickness of up to 5 nm. (e.g. up to 4.5 nm).

A silicon layer may be provided between the DUV suppressing layer and any adjacent layer. The silicon layer may provide improved adhesion between the DUV suppressing layer and the adjacent layers. The silicon layer may for example have a thickness of 1 nm. When the silicon layer is provided, then the depth that is available for the lower layer is reduced accordingly.

When silicon nitride is used as the DUV suppressing layer, the stoichiometry of the silicon nitride may be modified to improve its effectiveness. In particular, nitrogen deficiency may be used. Nitrogen deficiency of the silicon nitride reduces EUV absorption, thereby improving EUV reflectivity of the EUV reflector. In addition, nitrogen deficiency of the silicon nitride will reduce DUV absorption, thereby providing stronger destructive interference of DUV radiation (and thus stronger suppression of DUV radiation).

Description of embodiments of the invention refers to suppression of DUV radiation by the reflector. Since the DUV radiation is not reflected by the reflector, this suppression may be considered to be a form of absorption of DUV.

Although specific reference may be made in this text to embodiments of the invention in the context of a lithographic apparatus, embodiments of the invention may be used in other apparatus. Embodiments of the invention may form part of a mask inspection apparatus (or substrate inspection apparatus), a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An EUV reflector comprising:
a ruthenium capping layer,
a bilayer comprising an upper layer and a lower layer, and
a molybdenum silicon multilayer,
wherein the bilayer is positioned between the capping layer and the multilayer, and
wherein the upper layer comprises carbon, boron, boron carbide, silicon, molybdenum and/or mixtures thereof, and
wherein the lower layer comprises silicon nitride, amorphous carbon, diamond-like carbon, silicon carbide, boron nitride and/or mixtures thereof.

2. The EUV reflector of claim 1, wherein the ruthenium capping layer and the bilayer have a combined thickness of around 14 nm.

3. The EUV reflector of claim 1 or claim 2, wherein the lower layer of the bilayer has a thickness of at least 8 nm.

4. The EUV reflector of any preceding claim, wherein the lower layer of the bilayer has a thickness of around 10 nm.

5. The EUV reflector of claim 1, wherein the ruthenium capping layer and the bilayer have a combined thickness of around 7 nm.

6. The EUV reflector of claim 5, wherein the lower layer of the bilayer has a thickness of at least 5 nm.

7. The EUV reflector of any preceding claim, wherein the ruthenium capping layer has a thickness of between 1 and 2 nm.

8. The EUV reflector of any preceding claim, wherein a silicon layer is provided between the upper layer and the lower layer of the bilayer.

9. The EUV reflector of any preceding claim, wherein an optical path length from an upper surface of the ruthenium capping layer to a bottom surface of the bilayer is an integer multiple of 6.75 nm

10. An illumination system comprising a plurality of EUV reflectors, wherein at least one of the EUV reflectors is according to any preceding claim.

11. A projection system comprising a plurality of EUV reflectors, wherein at least one of the EUV reflectors is according to any of claims 1 to 9.

12. A lithographic apparatus, inspection apparatus or metrology apparatus comprising an illumination system according to claim 10.

13. A lithographic apparatus comprising a projection system according to claim 11.

14. A patterning device for use in a lithographic apparatus, wherein the patterning device comprises an EUV reflector according to any of claims 1 to 9.
